# EUROPEAN PATENT APPLICATION

(11) **EP 4 642 180 A1**
(43) Date of publication of application: **29.10.2025**
(21) Application number: 25170836.8
(22) Date of filing: 15.04.2025
(51) Int. Cl.: H05K 7/20

(54) **POWER MODULE AND CHARGING DEVICE**

(30) Priority: 20.04.2024 CN 202420835761 U
(71) Applicant: Huawei Digital Power Technologies Co., Ltd., Shenzhen, Guangdong 518043 (CN)
(72) Inventor: ZHANG, Zhidong, Shenzhen, 518043 (CN); QIU, Yuping, Shenzhen, 518043 (CN); CHEN, Caixing, Shenzhen, 518043 (CN); ZHANHUI, Jiang, Shenzhen, 518043 (CN); PAN, Denghai, Shenzhen, 518043 (CN)
(74) Representative: Gill Jennings & Every LLP

(57) **Abstract**

A power module and a charging device are provided. The power module includes a circuit board, a power transistor, a thermal conductor, a cooling plate, and a pressing structure. The cooling plate, the thermal conductor, the pressing structure, and the circuit board are sequentially stacked. The power transistor includes a body and a pin. The pin is exposed from the body. The body is located between the thermal conductor and the pressing structure. The pin passes through the pressing structure and is connected to the circuit board. The pressing structure is configured to tightly press the body and the thermal conductor. The pressing structure tightly presses the body and the thermal conductor, so that the body tightly presses the thermal conductor against the cooling plate, and the thermal conductor can be closely attached to the body and the cooling plate. This can reduce a possibility of forming a gap between the power transistor and the thermal conductor or between the thermal conductor and the cooling plate, thereby helping improve a heat dissipation capability of the power transistor.

## Description

### TECHNICAL FIELD

This application relates to the field of energy technologies, and in particular, to a power module and a charging device.

### BACKGROUND

With the development of new energy electric vehicles, the field of off-board charging develops rapidly. To meet requirements of fast charging, safe charging, long-term device stability, small size, and the like, power modules continuously decrease in size, and gradually increase in power density. This results in growingly severe heat generation in a power component (for example, a power transistor) on a circuit board, leading to an increasingly high requirement for an improved heat dissipation capability. In a common power module, a power transistor is fastened to a circuit board through wave soldering, and then a power component is fastened to a water cooling plate using a thermal conductive adhesive or the like, for heat dissipation. After long-term use, the thermal conductive adhesive ages, and reliability of the thermal conductive adhesive is reduced, reducing heat dissipation efficiency between the power component and the water cooling plate.

### SUMMARY

A technical problem to be resolved in embodiments of this application is to provide a power module that helps improve a heat dissipation capability, and a charging device.

According to a first aspect, this application provides a power module. The power module includes a circuit board, a power transistor, a thermal conductor, a cooling plate, and a pressing structure. The cooling plate, the thermal conductor, the pressing structure, and the circuit board are sequentially stacked. The power transistor includes a body and a pin. The pin is exposed from the body. The body is located between the thermal conductor and the pressing structure. The pin passes through the pressing structure and is connected to the circuit board. The pressing structure is configured to tightly press the body and the thermal conductor.

A thermal conductive adhesive ages over time with use. Consequently, a gap is formed between the thermal conductive adhesive and a water cooling plate or between the thermal conductive adhesive and a power component. Thermal resistance of air is relatively large. Therefore, if a gap is formed between the power component and the thermal conductive adhesive or between the thermal conductive adhesive and the water cooling plate, heat from the power component to the water cooling plate is reduced, affecting heat dissipation efficiency of the water cooling plate for the power component.

The pressing structure tightly presses the body and the thermal conductor, so that the body tightly presses the thermal conductor against the cooling plate, and the thermal conductor can be closely attached to the body and the cooling plate even after long-term use. This can reduce a possibility of forming a gap between the power transistor and the thermal conductor or between the thermal conductor and the cooling plate, thereby helping shorten a heat conduction path from the power transistor through the thermal conductor to the cooling plate and improve heat dissipation effect.

With reference to the first aspect, in a possible implementation, the power module further includes a fastener, one end of the fastener is located on a surface that is of the circuit board and that is away from the cooling plate, and the other end of the fastener passes through the circuit board and the pressing structure and is fastened to the cooling plate.

In this possible implementation, the circuit board, the pressing structure, and the cooling plate are fastened together using the fastener, so that the body and the cooling plate can be both closely attached to the thermal conductor through fastening by the fastener. This helps improve reliability of a connection between the thermal conductor, the power transistor, and the cooling plate, thereby helping improve a heat dissipation capability of the power module.

With reference to the first aspect, in a possible implementation, the pressing structure includes a housing and an elastic member, the elastic member is accommodated in the housing, the housing is provided with a positioning hole, at least a part of the body extends into the housing through the positioning hole, the elastic member elastically abuts against the body, and the elastic member is configured to exert an elastic force on the body in a direction toward the cooling plate.

In this possible implementation, the elastic member directly exerts the elastic force on the power transistor, so that the body can tightly press the thermal conductor. This improves reliability of a connection between the body and the thermal conductor, thereby helping improve the heat dissipation capability of the power module. In addition, the housing may be made of an insulating material. The housing performs insulation protection on the elastic member and the circuit board, to meet a requirement for insulation safety compliance between the elastic member and the circuit board. This helps improve safety of the power module. Besides, the positioning hole is provided on the housing, to perform positioning when the body extends into the housing, so that the pin of the power transistor is aligned with the circuit board for fastening. In addition, the positioning hole may further limit the body. When the elastic member exerts the elastic force on the body, a possibility that the body shifts in the housing is reduced. This helps the elastic member exert a stable elastic force on the thermal conductor through the body.

With reference to the first aspect, in a possible implementation, the pressing structure further includes an insulating member, the insulating member is accommodated in the housing, the insulating member is disposed between the elastic member and the body, and the elastic member elastically abuts against the body through the insulating member.

In this possible implementation, the insulating member is disposed between the elastic member and the power transistor, and performs insulation protection on the elastic member and the power transistor, to meet a requirement for insulation safety compliance between the elastic member and the power transistor. This helps improve the safety of the power module.

With reference to the first aspect, in a possible implementation, the insulating member includes a bottom wall and a side wall that are connected to each other, the bottom wall and the side wall jointly enclose accommodation space, and the accommodation space is used to accommodate the elastic member.

In this possible implementation, the side wall of the insulating member can wrap a side edge of the elastic member and perform insulation protection. This helps improve insulation safety compliance between the elastic member and another component.

With reference to the first aspect, in a possible implementation, the housing includes a top housing and a bottom housing, the top housing is connected to the bottom housing, the elastic member and the insulating member are both disposed between the top housing and the bottom housing, and the fastener sequentially passes through the circuit board, the top housing, the elastic member, the insulating member, and the bottom housing and is fastened to the cooling plate.

In this possible implementation, the fastener sequentially passes through the circuit board, the top housing, the elastic member, the insulating member, and the bottom housing, and is fastened to the cooling plate, to fasten the elastic member to the insulating member. As a result, the elastic member is kept in a compressed state, and keeps exerting an elastic force on the power transistor in the direction toward the cooling plate. This reduces a possibility of displacement of the elastic member and/or the insulating member in the housing, thereby helping improve reliability of the power module.

With reference to the first aspect, in a possible implementation, the elastic member includes an elastic part and a bent part that are connected to each other, two opposite ends of the elastic part are both provided with a bent part, the elastic part elastically abuts against the body, and the bent part is bent relative to the elastic part in an arrangement direction of the cooling plate and the circuit board.

In this possible implementation, the two opposite ends of the elastic part are provided with the bent part, so that the entire elastic member is roughly a "U"-shaped structure. This helps improve an elastic deformation capability of the elastic member.

With reference to the first aspect, in a possible implementation, the power transistor further includes a substrate, the substrate is disposed between the body and the thermal conductor, a surface that is of the substrate and that is away from the cooling plate is fastened to the body, and a surface that is of the substrate and that faces the cooling plate is attached to the thermal conductor.

In this possible implementation, the substrate is tightly attached between the thermal conductor and the body, to perform insulation protection on the body and the cooling plate. Heat generated by the body may be conducted to the thermal conductor through the substrate. This helps improve heat dissipation efficiency for the power transistor.

With reference to the first aspect, in a possible implementation, there are a plurality of power transistors, the plurality of power transistors are spaced apart and arranged on a surface of a side that is of the pressing structure and that is away from the circuit board, each body is correspondingly connected to one substrate, and a distance between a surface that is of each substrate and that faces the cooling plate and a surface that is of the circuit board and that faces the cooling plate is within a preset range.

In this possible implementation, the surface that is of the substrate and that faces the cooling plate is an attachment surface between the substrate and the thermal conductor. A distance between the attachment surface and the circuit board is within the preset range. The preset range may be determined based on an assembly tolerance of the power transistor and a height of the power transistor in the arrangement direction of the cooling plate and the circuit board. In this way, a difference between heights of the plurality of soldered power transistors is minimized, ensuring that a height tolerance of the soldered power transistors is within a required range. This helps reduce a possibility that a large stress on the power transistor is caused due to an excessively large difference between distances between the circuit board and different power transistors, thereby helping reduce a quantity of soldering times and reduce costs.

With reference to the first aspect, in a possible implementation, there is a spacing between the fastener and the power transistor in a direction perpendicular to an arrangement direction of the cooling plate and the circuit board.

In this possible implementation, the spacing is provided between the fastener and the power transistor, to prevent direct contact between the fastener and the power transistor. This reduces a safety compliance problem, thereby helping improve the safety of the power module.

According to a second aspect, a charging device is provided. The charging device includes the power module according to the first aspect or any one of the implementations of the first aspect and a charging connector connected to the charging device. The power module is configured to: perform power conversion on electric energy input to an input of the power module, and output converted electric energy to the charging connector.

According to a third aspect, a method for assembling a power module is provided. The method for assembling a power module includes: placing a pressing structure on a surface of a circuit board, causing a body of a power transistor to extend into the pressing structure from a side that is of the pressing structure and that is away from the circuit board, and causing a pin of the power transistor to pass through the pressing structure and extend out to a side that is of the circuit board and that is away from the pressing structure, where a substrate is located on a surface of a side that is of the body of the power transistor and that is away from the circuit board; causing a hook of a soldering auxiliary tool to sequentially pass through the circuit board, the pressing structure, and a screw hole on the soldering auxiliary tool, and fasten the hook to the soldering auxiliary tool; fastening the pin of the power transistor to the circuit board through soldering; and detaching the soldering auxiliary tool, placing a thermal conductor on the substrate, placing a cooling plate on the thermal conductor, and causing a fastener to sequentially pass through the circuit board, the pressing structure, and the cooling plate.

In the power module in this application, the soldering auxiliary tool is used to position the power transistor for soldering, so that a distance between a surface that is of each substrate and that faces the cooling plate and a surface that is of the circuit board and that faces the cooling plate is within a preset range. This ensures that a height tolerance of soldered power transistor is within a required range, thereby reducing a stress on the pin of the power transistor. As a result, a process of additional soldering or secondary wave soldering is reduced, and manufacturing costs are reduced.

### BRIEF DESCRIPTION OF DRAWINGS

To describe the technical solutions in embodiments of this application or in the background more clearly, the following describes the accompanying drawings for describing embodiments of this application or the background.
FIG. 1 is a diagram of a structure of a charging system according to an embodiment of this application;
FIG. 2 is a diagram of a connection structure of the charging system shown in (a) in FIG. 1;
FIG. 3 is a diagram of a three-dimensional structure of a power module according to an embodiment of this application;
FIG. 4 is a partial cross-sectional view of the power module shown in FIG. 3 along an IV-IV line;
FIG. 5 is a partial exploded view of a structure of a power module according to an embodiment of this application;
FIG. 6 is an exploded view of a structure of a pressing structure according to an embodiment of this application;
FIG. 7 is a diagram of assembly of a power transistor and a soldering auxiliary tool according to an embodiment of this application; and
FIG. 8 is a flowchart of assembly of a power module according to an embodiment of this application.

Reference numerals:
power module-100; casing-10; circuit board-20; cooling plate-30; thermal conductor-40; power transistor-50; body-51; pin-52; substrate-53; pressing structure-70; housing-71; bottom housing-711; top housing-712; inner cavity-713; positioning pin-714; positioning hole-715; installation hole-716; elastic member-72; elastic part-721; bent part-722; insulating member-73; a bottom wall-731; a side wall-732; a fastener-80; a soldering auxiliary tool-200; a hook-201; a charging device-300; a charging power unit-301; an AC-DC conversion module-3011; a DC-DC conversion module-3012; a direct current bus-3013; a power allocation module-3014; a charging terminal-302; a charging connector-303; an electric vehicle-400; a power grid-500; a charging system-1000.

### DESCRIPTION OF EMBODIMENTS

To make the objectives, technical solutions, and advantages of this application clearer, the following further describes this application in detail with reference to the accompanying drawings.

To facilitate understanding of the technical solutions provided in embodiments of this application, an application scenario to which embodiments of this application are applicable is first described.

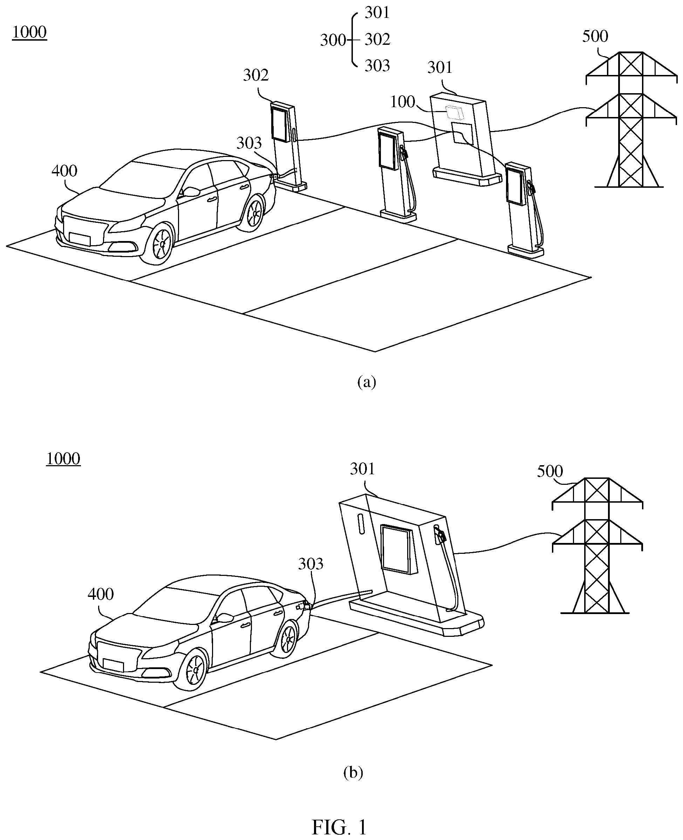

FIG. 1 is a diagram of a structure of a charging system 1000 according to an embodiment of this application. With reference to (a) and (b) in FIG. 1, the charging system 1000 may include a charging device 300 and an electric vehicle 400. The charging device 300 is configured to: receive an output alternating current, convert the alternating current into a stable direct current, and transmit the stable direct current to the electric vehicle 400, to charge the electric vehicle 400. Alternatively, the electric vehicle 400 may output electric energy to a power grid 500 through the charging device 300 in reverse.

The charging device 300 includes a power module 100 and a charging connector 303 connected to the power module 100. The power module 100 is configured to: perform power conversion on electric energy input to an input of the power module 100, and output converted electric energy to the charging connector 303.

In some embodiments, as shown in (a) in FIG. 1, the charging device 300 is a split charging device. Specifically, the charging device 300 includes a charging power unit 301, at least one charging terminal 302, and at least one charging connector 303. The charging power unit 301 is connected to each charging terminal 302. The at least one charging terminal 302 is connected to the at least one charging connector 303. Each charging connector 303 is configured to connect to the electric vehicle 400. During specific implementation, one charging terminal 302 is connected to one or more charging connectors 303, and the one or more charging connectors 303 are connected to one electric vehicle 400.

The charging power unit 301 includes a plurality of power modules 100. The plurality of power modules are configured to: convert an alternating current output by the power grid 500 into a stable direct current, and transmit the stable direct current to the charging terminal 302. The plurality of power modules include, for example, an alternating current-direct current (alternating current-direct current, AC-DC) conversion module and a DC-DC conversion module. The charging terminal 302 transmits the stable direct current to the electric vehicle 400 through the connected charging connector 303.

The charging terminal 302 includes a casing, a human-machine interaction interface, a charging control unit, a metering and billing unit, and the like, and is configured to perform information exchange, energy transmission, metering and billing, and the like with the electric vehicle 400.

The electric vehicle 400 is a transportation means driven by electric energy. The electric vehicle 400 is a pure electric vehicle (pure electric vehicle/battery electric vehicle, pure EV/battery EV), a hybrid electric vehicle (hybrid electric vehicle, HEV), a range extended electric vehicle (range extended electric vehicle, REEV), a plug-in hybrid electric vehicle (plug-in hybrid electric vehicle, PHEV), or the like.

In some other embodiments, as shown in (b) in FIG. 1, the charging device 300 is an integrated charging device. Specifically, a human-machine interaction interface, a charging control unit, a metering and billing unit, and the like in the charging device 300 are directly disposed in the charging power unit 301, so that the charging device 300 includes only a charging power unit 301 and at least one charging connector 303 connected to the charging power unit 301, and does not include a charging terminal 302. During specific implementation, a plurality of power modules in the charging power unit 301 converts an alternating current output by the power grid 500 into a stable direct current, and directly transmits the stable direct current to the electric vehicle 400 through the charging connector 303. The plurality of power modules include, for example, an AC-DC conversion module.

The following further describes a structure of the charging power unit 301 by using the charging system 1000 shown in (a) in FIG. 1 as an example.

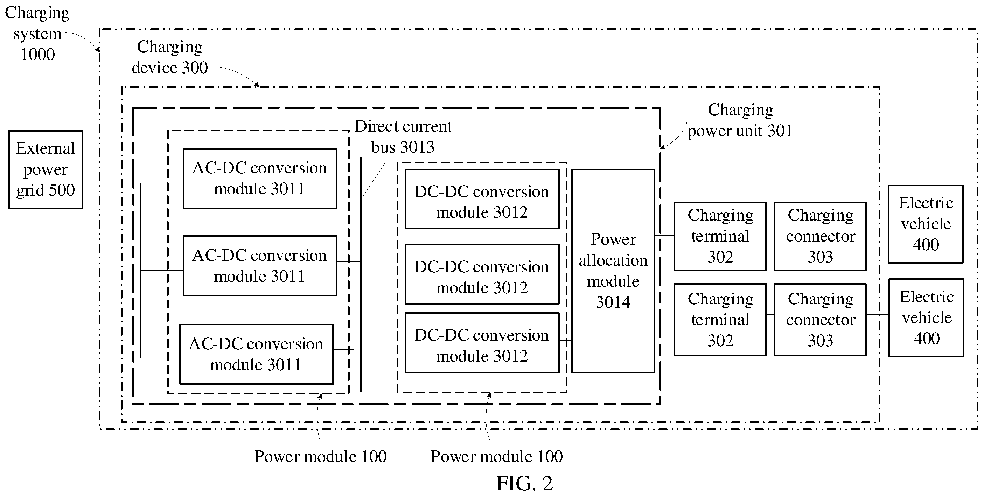

FIG. 2 is a diagram of an example of a connection structure of the charging system 1000 shown in (a) in FIG. 1.

Refer to FIG. 2. The charging power unit 301 includes a plurality of AC-DC conversion modules 3011, a plurality of DC-DC conversion modules 3012, a direct current bus 3013, and a power allocation module 3014. An input of each AC-DC conversion module 3011 is connected to the power grid 500, and an output of each AC-DC conversion module 3011 is connected to the direct current bus 3013. An input of each DC-DC conversion module 3012 is connected to the direct current bus 3013, and an output of each DC-DC conversion module 3012 is connected to an input of the power allocation module 3014. An output of the power allocation module 3014 is connected to the charging connector 303 through the charging terminal 302.

The plurality of AC-DC conversion modules 3011 are configured to: receive an alternating current output by the power grid 500, convert the alternating current into a direct current, and output the direct current to the direct current bus 3013. The plurality of DC-DC conversion modules 3012 are configured to: obtain the direct current from the direct current bus 3013, further convert the obtained direct current into a direct current suitable for the electric vehicle 400, and output the direct current suitable for the electric vehicle 400 to the power allocation module 3014. The power allocation module 3014 is configured to: perform, based on a charging power actually required by the electric vehicle 400, dynamic allocation for the direct current output by the plurality of DC-DC conversion modules 3012, and transmit an allocated charging power to the electric vehicle 400 through the charging connector 303.

With the development of new energy electric vehicles, the field of off-board charging develops rapidly. To meet requirements of fast charging, safe charging, long-term device stability, small size, and the like, a power module continuously decreases in size, but gradually increases in power density. This results in growingly severe heat generation in a power component (for example, a power transistor) on a circuit board, leading to an increasingly high requirement for an improved heat dissipation capability. In a common power module, a power transistor is fastened to a circuit board through wave soldering, and then a power component is fastened to a water cooling plate using a thermal conductive adhesive or the like, for heat dissipation. After long-term use, the thermal conductive adhesive ages, and reliability of the thermal conductive adhesive is reduced, reducing heat dissipation efficiency between the power component and the water cooling plate.

To resolve the foregoing problem, this application provides a power module 100 that helps improve a heat dissipation capability, so that power utilization of the power module 100 can be improved while charging powers required by different loads can be provided. This helps the charging device 300 achieve a charging rate of one kilometer per second, bringing charging experience of "having your vehicle fully charged after taking a coffee break" to a user.

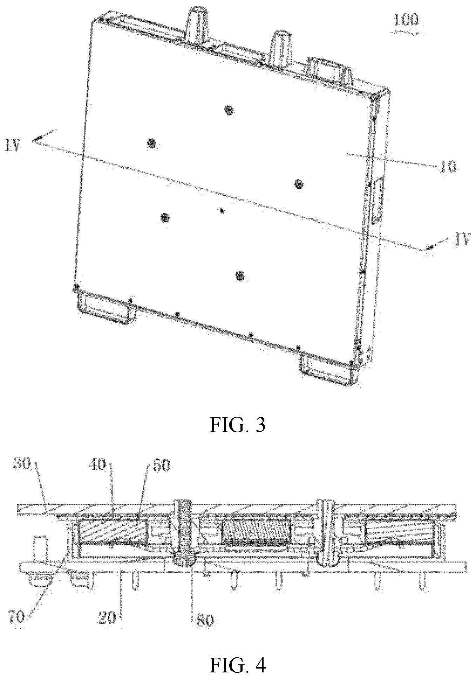

Refer to FIG. 3 and FIG. 4. FIG. 3 is a diagram of a three-dimensional structure of a power module 100 according to an embodiment of this application. FIG. 4 is a partial cross-sectional view of the power module 100 shown in FIG. 3 along an IV-IV line. The power module 100 includes a casing 10, a circuit board 20, a cooling plate 30, a thermal conductor 40, a power transistor 50, a pressing structure 70, and a fastener 80. The circuit board 20, the cooling plate 30, the thermal conductor 40, the pressing structure 70, and the power transistor 50 are all accommodated in the casing 10. The cooling plate 30 is fastened to the casing 10. For example, the cooling plate 30 and the casing 10 may be integrated as a single unit, simplifying an installation process. The circuit board 20, the pressing structure 70, the thermal conductor 40, and the cooling plate 30 are sequentially stacked. The circuit board 20, the pressing structure 70, and the cooling plate 30 are fastened together using a fastener 80 (for example, a screw), so that the pressing structure 70 can stably exert a force on the power transistor 50. The power transistor 50 is disposed between the circuit board 20 and the cooling plate 30. A surface that is of the power transistor 50 and that faces the thermal conductor 40 is configured to be attached to the thermal conductor 40, and an end that is of the power transistor 50 and that is away from the thermal conductor 40 passes through the pressing structure 70 and is connected to the circuit board 20.

The thermal conductive adhesive ages over time with use. Consequently, a gap is formed between the thermal conductive adhesive and the water cooling plate or between the thermal conductive adhesive and the power component. Thermal resistance of air is relatively large. Therefore, if a gap is formed between the power component and the thermal conductive adhesive or between the thermal conductive adhesive and the water cooling plate, heat from the power component to the water cooling plate is reduced, affecting heat dissipation efficiency of the water cooling plate for the power component.

In this application, the pressing structure 70 is configured to exert a force on the power transistor 50 in a direction toward the cooling plate 30, so that the power transistor 50 tightly presses the thermal conductor 40 against the cooling plate 30. As a result, the thermal conductor 40 can be closely attached to the power transistor 50 and the cooling plate 30 even after long-term use. This reduces a possibility of forming a gap between the power transistor 50 and the thermal conductor 40 or between the thermal conductor 40 and the cooling plate 30, thereby helping shorten a heat conduction path from the power transistor 50 through the thermal conductor 40 to the cooling plate 30 and helping improve heat dissipation effect. The pressing structure 70 and the cooling plate 30 are fastened together using the fastener 80, so that the power transistor 50 and the cooling plate 30 can be both closely attached to the thermal conductor 40. This helps improve reliability of a connection between the thermal conductor 40, the power transistor 50, and the cooling plate 30, thereby helping improve a heat dissipation capability of the power transistor 50. In addition, the pressing structure 70 does not directly exert a force on the circuit board 20. This effectively reduces a degree of damage to the circuit board 20, thereby helping extend a service life of the circuit board 20.

For example, the cooling plate 30 may be a liquid cooling plate, and the cooling plate 30 may be fed with coolant to dissipate heat for the power transistor 50.

The thermal conductor 40 is thermal conductive gel, thermal conductive grease, a thermal conductive pad, or the like. The thermal conductor 40 can deform under the force exerted by the pressing structure 70 on the power transistor 50, to fill a gap between the power transistor 50 and the cooling plate 30 and therefore accelerate heat dissipation for the power transistor 50.

For example, the power transistor 50 may be an insulated gate bipolar transistor (insulated gate bipolar transistor, IGBT), an insulated gate field effect transistor (metal-oxide-semiconductor field-effect transistor, MOSFET, briefly referred to as a MOS transistor), or a diode. It may be understood that the power transistor 50 may alternatively be of another type. This is not specifically limited.

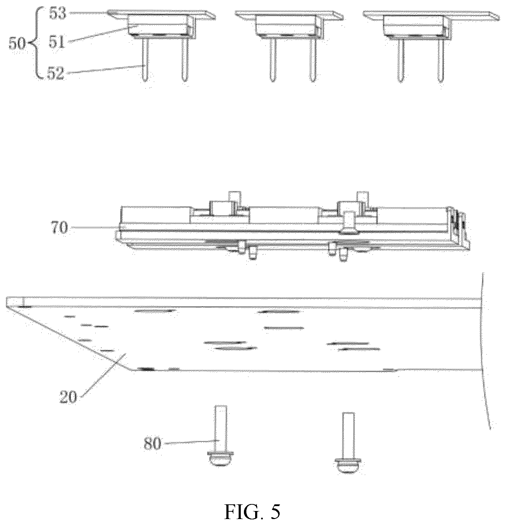

FIG. 5 is a partial exploded view of a structure of a power module 100 according to an embodiment of this application. The power transistor 50 may be fastened to the circuit board 20 through wave soldering. Specifically, the power transistor 50 includes a body 51, a pin 52, and a substrate 53. The body 51 is fastened to the pin 52. The pin 52 is exposed from the body 51. The pin 52 passes through the pressing structure 70 and is fastened to the circuit board 20. The pin 52 is fastened to the circuit board 20 through wave soldering. The substrate 53 is disposed between the body 51 and the thermal conductor 40. A surface that is of the substrate 53 and that is away from the cooling plate 30 is fastened to the body 51. A surface that is of the substrate 53 and that faces the cooling plate 30 is attached to the thermal conductor 40. Based on such configuration, the substrate 53 is tightly attached between the thermal conductor 40 and the body 51, to perform insulation protection on the body 51 and the cooling plate 30. Heat generated by the body 51 may be conducted to the thermal conductor 40 through the tightly attached substrate 53. This helps improve heat dissipation efficiency for the power transistor 50.

There may be a plurality of power transistors 50. The plurality of power transistors 50 are spaced apart and arranged on a surface of a side that is of the pressing structure 70 and that is away from the circuit board 20. Each power transistor 50 may be correspondingly connected to one thermal conductor 40. In this way, a material of the thermal conductor 40 can be effectively saved, helping reduce costs.

For example, when there are a plurality of power transistors 50, each body is correspondingly connected to one substrate 53. Such configuration helps improve flatness of the substrate 53, so that the substrate 53 is better attached to the thermal conductor 40, thereby helping improve heat dissipation efficiency.

After the plurality of power transistors 50 are all fastened to the circuit board 20, the pressing structure 70 simultaneously exerts forces on a plurality of bodies 51 in the direction toward the cooling plate 30. If a difference between heights to the circuit board 20 from surfaces of sides that are of different substrates 53 and that face the cooling plate 30 is excessively large in an arrangement direction of the cooling plate 30 and the circuit board 20, it is likely to cause an excessive stress on a pin 52 of a part of the power transistors 50. To reduce a stress on the pin 52 of the power transistor 50, there is a need to perform additional soldering after the wave soldering or perform wave soldering gain after the wave soldering. Consequently, a soldering process of the power transistor 50 is complex and low in efficiency, and costs are high.

A distance between a surface that is of each substrate 53 and that faces the cooling plate 30 and a surface that is of the circuit board 20 and that faces the cooling plate 30 is within a preset range. The surface that is of the substrate 53 and that faces the cooling plate 30 is an attachment surface between the substrate 53 and the thermal conductor 40. A distance between the attachment surface and the circuit board 20 is within the preset range. The preset range may be determined based on an assembly tolerance of the power transistor 50 and a height of the power transistor 50 in the arrangement direction of the cooling plate 30 and the circuit board 20. In this way, a difference between heights of the plurality of soldered power transistors 50 is minimized, ensuring that a height tolerance of the soldered power transistors 50 is within a required range. This helps reduce a possibility that a large stress on the power transistor 50 is caused due to an excessively large difference between distances between the circuit board 20 and different power transistors 50, thereby helping reduce a quantity of soldering times and reduce costs.

For example, surfaces of sides that are of a plurality of substrates 53 and that face the cooling plate 30 are located on a same plane, and the plane is perpendicular to the arrangement direction of the cooling plate 30 and the circuit board 20. This helps improve consistency of distances between the circuit board 20 and the plurality of power transistors 50. As a result, stresses on pins 52 of the plurality of power transistors 50 fastened to the circuit board 20 through soldering are basically consistent, a possibility that a large stress on the pin 52 of the power transistor 50 is caused due to different distances between the circuit board 20 and the power transistors 50 is reduced, and additional soldering or secondary wave soldering is reduced. This helps improve processing efficiency, reduce the costs, and improve reliability of a connection between the power transistor 50 and the circuit board 20.

As shown in FIG. 4, for example, there is a spacing between the fastener 80 and the power transistor 50 in a direction perpendicular to the arrangement direction of the cooling plate 30 and the circuit board 20. The fastener 80 is fastened to the circuit board 20, and the spacing is provided between the fastener 80 and the power transistor 50, to prevent direct contact between the fastener 80 and the power transistor 50. This helps improve safety of the power module 100.

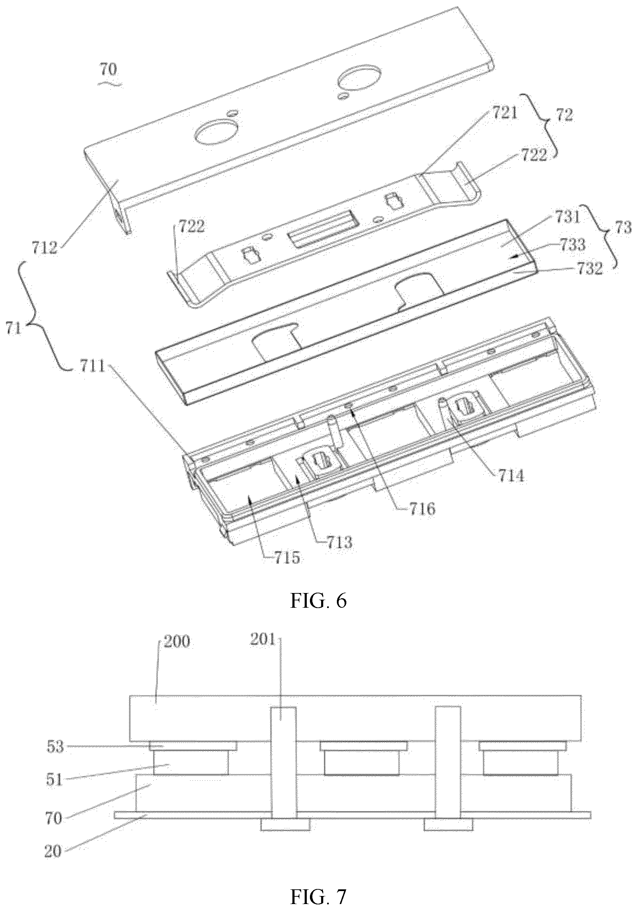

FIG. 6 is an exploded view of a structure of a pressing structure 70 according to an embodiment of this application. The pressing structure 70 includes a housing 71, an elastic member 72, and an insulating member 73. The housing 71 is configured to accommodate the elastic member 72, the insulating member 73, and at least a part of the body 51. The elastic member 72, the insulating member 73, and the power transistor 50 are stacked in the arrangement direction of the cooling plate 30 and the circuit board 20. The elastic member 72 elastically abuts against the body 51. Specifically, the elastic member 72 elastically abuts against the body 51 through the insulating member 73. The elastic member 72 is configured to exert an elastic force on the body 51 in the direction toward the cooling plate 30. It should be noted that the elastic member 72 may be fastened to the housing 71, to exert a stable elastic force on the body 51. The elastic member 72 directly exerts the elastic force on the body 51, so that the body 51 can tightly press the thermal conductor 40. This improves reliability of a connection between the body 51 and the thermal conductor 40, thereby helping improve a heat dissipation capability of the power module 100.

The insulating member 73 is disposed between the elastic member 72 and the power transistor 50, and is configured to perform insulation protection on the power transistor 50 and the elastic member 72, to meet a requirement for insulation safety compliance between the elastic member 72 and the power transistor 50. In addition, the housing 71 serves as an insulation protection component between the elastic member 72 and the circuit board 20, to meet a requirement for insulation safety compliance between the elastic member 72 and the circuit board 20. This helps improve the safety of the power module 100.

The housing 71 may be made of an insulating plastic material and be of a specific rigidity, so that the housing 71 is not prone to deformation and therefore performs functions of supporting and fastening the elastic member 72.

The housing 71 includes a bottom housing 711 and a top housing 712. The bottom housing 711 and the top housing 712 are fastened together and enclose an inner cavity 713. The inner cavity 713 is configured to accommodate the elastic member 72, the insulating member 73, and at least the part of the body 51. The top housing 712 and the bottom housing 711 are an external structure of the entire pressing structure 70, and are mainly used to provide installation space for the internal elastic member 72 and the internal insulating member 73 and prevent direct contact between the internal elastic member 72 and a circuit or a component on the circuit board 20. This helps improve the safety of the power module 100.

For example, the top housing 712, the elastic member 72, the insulating member 73, and the bottom housing 711 are sequentially stacked, and the top housing 712 is fastened to the circuit board 20. The fastener 80 sequentially passes through the circuit board 20, the top housing 712, the elastic member 72, the insulating member 73, and the bottom housing 711, and is fastened to the cooling plate 30, to fasten the elastic member 72 to the insulating member 73. As a result, the elastic member 72 is kept in a compressed state, and keeps exerting an elastic force on the body 51 in the direction toward the cooling plate 30. This reduces a possibility of displacement of the elastic member 72 and/or the insulating member 73 in the housing 71, thereby helping improve reliability of the power module 100.

It should be noted that, after the fastener 80 passes through the circuit board 20 and the pressing structure 70 and is fastened to the cooling plate 30, the elastic member 72 elastically deforms to some extent under pressure of the fastener 80, providing the elastic force for the body 51. Under the elastic force of the elastic member 72, the thermal conductor 40 fully fills a gap between the substrate 53 and the cooling plate 30. This improves heat dissipation effect of the power transistor 50.

For example, the bottom housing 711 is provided with a positioning pin 714, and the circuit board 20 is provided with a hole corresponding to the positioning pin 714. The positioning pin 714 may pass through the top housing 712 and fit into the hole on the circuit board 20, ensuring that a relative position of the pressing structure 70 is not prone to change, and performing a positioning function for subsequent assembly of the power transistor 50.

For example, the bottom housing 711 is further provided with a positioning hole 715 and an installation hole 716, and there is a spacing between the positioning hole 715 and the installation hole 716. The positioning hole 715 is used for the body 51 of the power transistor 50 to extend into the inner cavity 713 of the housing 71 and abut against the elastic member 72 through the insulating member 73. The installation hole 716 is used for the pin 52 of the power transistor 50 to pass through the bottom housing 711 and be fastened to the circuit board 20. A quantity of positioning holes 715 is the same as a quantity of power transistors 50, and one positioning hole 715 may correspond to one or more installation holes 716, so that one or more pins 52 of the power transistor 50 can be fastened to the circuit board 20 through a corresponding installation hole 716 after the body 51 of the power transistor 50 passes through a positioning hole 715.

Specifically, a hole size of the positioning hole 715 matches a size of the body 51 of the power transistor 50, and therefore the positioning hole 715 may further position the power transistor 50, so that subsequently the pin 52 of the power transistor 50 can accurately pass through the installation hole 716 and be fastened to the circuit board 20. In addition, the positioning hole 715 may further limit the body 51. When the elastic member 72 exerts the elastic force on the body 51, a possibility that the body 51 shifts in the housing 71 is reduced. This helps the elastic member 72 exert a stable elastic force on the thermal conductor 40 through the body 51.

In this application, in the arrangement direction of the circuit board 20 and the cooling plate 30, an area of orthographic projection of the bottom housing 711 on the circuit board 20 is larger than an area of orthographic projection of the top housing 712 on the circuit board 20. In other words, the bottom housing 711 covers the area of orthographic projection of the top housing 712 on the circuit board 20. Based on such configuration, after the power transistor 50 extends into the inner cavity 713 from a side that is of the bottom housing 711 and that is away from the top housing 712, the one or more pins 52 of the power transistor 50 only needs to be aligned with the installation hole 716 on the bottom housing 711 to be aligned with a hole on the circuit board 20, and the one or more pins 52 of the power transistor 50 can be connected to the circuit board 20 without passing through the top housing 712. As a result, installation precision is reduced, and assembly of a power transistor 50 having a plurality of pins 52 is convenient. This helps improve installation efficiency.

The elastic member 72 includes an elastic part 721 and a bent part 722 that are connected to each other. Two opposite ends of the elastic part 721 are both provided with a bent part 722. The elastic part 721 elastically abuts against the body 51. For example, the elastic part 721 elastically abuts against the body 51 of the power transistor 50 through the insulating member 73, to provide an elastic force for the body 51 of the power transistor 50. The bent part 722 is bent relative to the elastic part 721 in the arrangement direction of the cooling plate 30 and the circuit board 20. For example, the bent part 722 is bent toward the circuit board 20 relative to the elastic part 721 in the arrangement direction of the cooling plate 30 and the circuit board 20. For another example, the bent part 722 may be bent toward the cooling plate 30 relative to the elastic part 721 in the arrangement direction of the cooling plate 30 and the circuit board 20. Based on such configuration, the entire elastic member 72 is roughly a "U"-shaped structure. This helps improve an elastic deformation capability of the elastic member 72.

For example, the elastic member 72 may be a metal dome. The metal dome simultaneously exerts elastic forces on the plurality of power transistors 50 in the direction toward the cooling plate 30, to improve consistency of forces exerted on the plurality of bodies 51. As a result, distances between the circuit board 20 and the surfaces of the sides that are of the plurality of substrates 53 and that are away from the circuit board 20 are within the preset range, thereby ensuring that the height tolerance of the soldered power transistors 50 is within the required range. It may be understood that the elastic member 72 may alternatively be an elastic component made of an insulating material. This is not specifically limited.

For example, the insulating member 73 may be an insulating film, which may be attached to a surface of a side that is of the elastic member 72 and that faces the power transistor 50. The insulating member 73 may alternatively be made of another type of insulating material. This is not specifically limited.

For example, the insulating member 73 includes a bottom wall 731 and a side wall 732 that are connected to each other. For example, the side wall 732 is connected to an outer edge of the bottom wall 731. The side wall 732 and the bottom wall 731 jointly enclose accommodation space 733. The accommodation space 733 is used to accommodate the elastic member 72. Based on such configuration, at least a part of the elastic member 72 is accommodated in the insulating member 73, so that the side wall 732 of the insulating member 73 can wrap a surrounding side edge of the elastic member 72 and perform an insulation protection function. This helps improve insulation safety compliance between the elastic member 72 and another component.

FIG. 7 is a diagram of assembly of a power transistor 50 and a soldering auxiliary tool 200 according to an embodiment of this application. This application further provides a soldering auxiliary tool 200. The soldering auxiliary tool 200 is configured to work with the pressing structure 70 to position the power transistor 50 for soldering. The soldering auxiliary tool 200 may be a flat plate structure, and be provided with a screw hole. The screw hole is used for a hook 201 to pass through, to simulate a locking function of a screw. The soldering auxiliary tool 200 is configured to cause distances between the surface that is of the circuit board 20 and that faces the cooling plate 30 and the surfaces that are of the plurality of substrates 53 and that are away from the circuit board 20 are within the preset range, to ensure that the height tolerance of the wave-soldered power transistors 50 is within the required range.

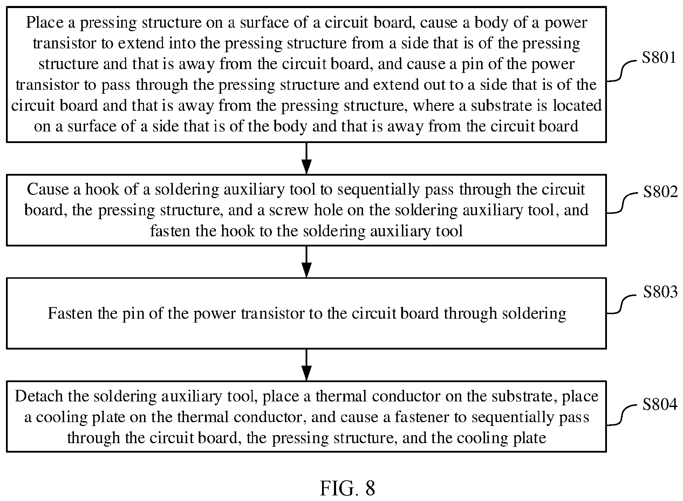

FIG. 8 is a flowchart of assembly of a power module 100 according to an embodiment of this application. Specifically, the power module 100 in this application may be assembled using a soldering auxiliary tool 200. A method for assembling the power module 100 includes steps S801 to S804.

S801: Place a pressing structure 70 on a surface of a circuit board 20, cause a body 51 of a power transistor 50 to extend into the pressing structure 70 from a side that is of the pressing structure 70 and that is away from the circuit board 20, and cause a pin 52 of the power transistor 50 to pass through the pressing structure 70 and extend out to a side that is of the circuit board 20 and that is away from the pressing structure 70, where a substrate 53 is located on a surface of a side that is of the body 51 and that is away from the circuit board 20.

Step S801 is performed in an insertion assembly stage that is before wave soldering is performed on the circuit board 20.

S802: Cause a hook 201 of the soldering auxiliary tool 200 to sequentially pass through the circuit board 20, the pressing structure 70, and a screw hole on the soldering auxiliary tool 200, and fasten the hook 201 to the soldering auxiliary tool 200.

In step S802, after the hook 201 fastens the circuit board 20 and the pressing structure 70 to the soldering auxiliary tool 200, an elastic member 72 elastically deforms to some extent under pressure of the hook 201, where an elastic restoring force of the elastic member 72 is toward the soldering auxiliary tool 200. Under the action of the soldering auxiliary tool 200, a distance between a surface of a side that is of the soldering auxiliary tool 200 and that faces the circuit board 20 and a surface of a side that is of the circuit board 20 and that faces the pressing structure 70 is controlled within a proper range, to ensure that a height tolerance of wave-soldered power transistors 50 is within a required range.

S803: Fasten the pin 52 of the power transistor 50 to the circuit board 20 through soldering.

In step S803, the pin 52 of the power transistor 50 may be fastened to the circuit board 20 through wave soldering. After the power transistor 50 is fastened to the circuit board 20, a distance between a surface that is of each substrate 53 and that is away from the circuit board 20 and a surface that is of the circuit board 20 and that faces a cooling plate 30 is within a preset range.

S804: Detach the soldering auxiliary tool 200, place a thermal conductor 40 on the substrate 53, place the cooling plate 30 on the thermal conductor 40, and cause a fastener 80 to sequentially pass through the circuit board 20, the pressing structure 70, and the cooling plate 30.

In step S804, after the soldering auxiliary tool 200 is detached, because the power transistor 50 is already fastened to the circuit board 20, the substrate 53 disposed on the power transistor 50 is not prone to displacement under an elastic force of the elastic member 72. After the circuit board 20, the pressing structure 70, and the cooling plate 30 are fastened together, the elastic force of the elastic member 72 to recover from elastic deformation pushes the power transistor 50 and the substrate 53 toward the thermal conductor 40 to some extent, so that the thermal conductor 40 fully fills a gap between the substrate 53 and the cooling plate 30. This helps improve a heat dissipation capability of the power transistor 50.

In conclusion, in the power module 100 in this application, heat generated by the power transistor 50 is conducted to the cooling plate 30 through the thermal conductor 40 to implement heat dissipation. Therefore, a heat conduction path is relatively short, which helps improve heat dissipation efficiency. In addition, a manner of increasing pressure on the thermal conductor 40 by using the elastic member 72 in the pressing structure 70 is highly reliable. This helps improve reliability of a connection between the power transistor 50 and the thermal conductor 40, thereby helping improve a heat dissipation capability of the power transistor 50. Besides, the entire pressing structure 70 is an integrated design that combines positioning of the power transistor 50, providing a force to attach the power transistor 50 to the cooling plate 30, and insulating the internal elastic member 72 from a peripheral circuit or the power transistor 50. This simplifies an assembly process of the power module 100, thereby helping reduce costs. In addition, in the power module 100 in this application, the soldering auxiliary tool 200 is used to position the power transistor 50 for soldering, so that the distance between the surface that is of each substrate 53 and that faces the cooling plate 30 and the surface that is of the circuit board 20 and that faces the cooling plate 30 is within the preset range. This ensures that the height tolerance of the soldered power transistors 50 is within the required range, thereby reducing a stress on the pin 52 of the power transistor 50. As a result, a process of additional soldering or secondary wave soldering is reduced, and manufacturing costs are reduced.

In this application, unless otherwise specified and limited, terms "connected", "fastened", and the like should be understood in a broad sense. For example, "fastened" may indicate a fixed connection, a detachable connection, or an integrated connection; may indicate a mechanical connection or an electrical connection; or may indicate a direct connection, an indirect connection through an intermediate medium, or internal communication between two elements or an interaction relationship between two elements, unless otherwise specified. Persons of ordinary skill in the art may understand specific meanings of the foregoing terms in this application based on specific situations.

"First", "second", and various numbers in this specification are merely used for differentiation for ease of description, but are not intended to limit the scope of this application.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

The foregoing embodiments are merely intended for describing the technical solutions of this application rather than limiting this application. Although this application is described in detail with reference to the foregoing embodiments, the persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. A power module, comprising a circuit board, a power transistor, a thermal conductor, a cooling plate, and a pressing structure, wherein the cooling plate, the thermal conductor, the pressing structure, and the circuit board are sequentially stacked; and
the power transistor comprises a body and a pin, the pin is exposed from the body, the body is located between the thermal conductor and the pressing structure, the pin passes through the pressing structure and is connected to the circuit board, and the pressing structure is configured to tightly press the body and the thermal conductor.

2. The power module according to claim 1, wherein the power module further comprises a fastener, one end of the fastener is located on a surface that is of the circuit board and that is away from the cooling plate, and the other end of the fastener passes through the circuit board and the pressing structure and is fastened to the cooling plate.

3. The power module according to claim 2, wherein the pressing structure comprises a housing and an elastic member, the elastic member is accommodated in the housing, the housing is provided with a positioning hole, at least a part of the body extends into the housing through the positioning hole, the elastic member elastically abuts against the body, and the elastic member is configured to exert an elastic force on the body in a direction toward the cooling plate.

4. The power module according to claim 3, wherein the pressing structure further comprises an insulating member, the insulating member is accommodated in the housing, the insulating member is disposed between the elastic member and the body, and the elastic member elastically abuts against the body through the insulating member.

5. The power module according to claim 4, wherein the insulating member comprises a bottom wall and a side wall that are connected to each other, the bottom wall and the side wall jointly enclose accommodation space, and the accommodation space is used to accommodate the elastic member.

6. The power module according to claim 5, wherein the housing comprises a top housing and a bottom housing, the top housing is connected to the bottom housing, the elastic member and the insulating member are both disposed between the top housing and the bottom housing, and the fastener sequentially passes through the circuit board, the top housing, the elastic member, the insulating member, and the bottom housing and is fastened to the cooling plate.

7. The power module according to claim 3, wherein the elastic member comprises an elastic part and a bent part that are connected to each other, two opposite ends of the elastic part are both connected to the bent part, the elastic part elastically abuts against the body, and the bent part protrudes relative to the elastic part.

8. The power module according to claim 1, wherein the power transistor further comprises a substrate, the substrate is disposed between the body and the thermal conductor, a surface that is of the substrate and that is away from the cooling plate is fastened to the body, and a surface that is of the substrate and that faces the cooling plate is attached to the thermal conductor.

9. The power module according to claim 8, wherein there are a plurality of power transistors, the plurality of power transistors are spaced apart and arranged on a surface of a side that is of the pressing structure and that is away from the circuit board, each body is correspondingly connected to one substrate, and a distance between a surface that is of each substrate and that faces the cooling plate and a surface that is of the circuit board and that faces the cooling plate is within a preset range.

10. The power module according to claim 2, wherein there is a spacing between the fastener and the power transistor in a direction perpendicular to an arrangement direction of the cooling plate and the circuit board.

11. A charging device, comprising the power module according to any one of claims 1 to 10 and a charging connector connected to the power module, wherein the power module is configured to: perform power conversion on electric energy input to an input of the power module, and output converted electric energy to the charging connector.
